## Europäisches Patentamt
## European Patent Office
## Office européen des brevets

(11) Publication number: **0 033 793**
**B1**

# EUROPEAN PATENT SPECIFICATION

(45) Date of publication of patent specification: **09.05.84**

(51) Int. Cl.³: **G 11 B 5/42, C 23 C 13/08**

(21) Application number: **80300369.8**

(22) Date of filing: **07.02.80**

(54) Method of forming a glass spacer in the magnetic gap of a magnetic head.

(43) Date of publication of application:
**19.08.81 Bulletin 81/33**

(45) Publication of the grant of the patent:
**09.05.84 Bulletin 84/19**

(84) Designated Contracting States:
**AT DE FR GB**

(56) References cited:
**DE - A - 2 146 818**
**DE - A - 2 624 700**
**DE - U - 1 927 881**
**GB - A - 1 081 324**
**US - A - 3 458 926**
**US - A - 3 605 258**

**INSTRUMENTS AND EXPERIMENTAL TECHNIQUES, Vol. 17, No. 6, November to December 1974 New York V.N. CHERNYAEV et al. "Continuous Monitoring of the Thickness and Deposition and Etching Rates of Dielectric and Semiconducting Films"**

(73) Proprietor: **Matsushita Electric Industrial Co., Ltd.**
**1006, Oaza Kadoma**
**Kadoma-shi Osaka-fu, 571 (JP)**

(72) Inventor: **Wasa, Kiyotaka**
**7-27, Chiyogaoka 2 chome**
**Nara-shi Nara-ken (JP)**
Inventor: **Tohda, Takao**
**11-38, Nishiasahigaoka**
**Ikoma-shi Nara-ken (JP)**
Inventor: **Yokoyama, Kazuo**
**542, Awajihonmachi 2 chome**
**Higashiyodogawa-ku Osaka-shi Osaka-fu (JP)**
Inventor: **Hirota, Eiichi**
**26-9, Yamanoue 1 chome**
**Kirakata-shi Osaka-fu (JP)**
Inventor: **Hayakawa, Shigeru**
**16-13, Kohrigaoka 7 chome**
**Hirakata-shi Osaka-fu (JP)**

(74) Representative: **Spencer, Graham Easdale et al, A.A. Thornton & CO Northumberland House 303-306, High Holborn London WC1V 7LE (GB)**

Courier Press, Leamington Spa, England.

## Description

The present invention relates to a method of forming a glass spacer within the magnetic gap of a magnetic head, as described in the first part of the independent claim of this application.

In the production of magnetic heads for recording and reproducing video signals and sound signals, a magnetic gap comprising a non-magnetic spacer element is frequently made of glass material. There are known several methods for producing such glass spacer elements, such as by immersing a magnetic head element in a mixed solution of finely-crushed glass, followed by centrifuging so that a homogeneous layer of pulverized glass is deposited on the gap-facing surfaces of the head elements. After forming a glass film by stoving the thus deposited glass layer, the two gap-facing faces of the head elements are butted against each other with the glass film sandwiched therebetween, followed by fusion by heat treatment to form a desired operative gap. Such a method has the disadvantages that it is difficult to produce a magnetic gap with high precision because of the difficulty of controlling the stoved glass film thickness.

U.S. Patent 3458926 discloses a method of forming a glass spacer in a magnetic head comprising said glass spacer element sandwiched between magnetic head elements, which method comprises a cathodic sputtering of at least one glass layer onto one or both head elements and cementing the head elements together with the glass layer or layers therebetween. There have been a number of developments on this method of producing a magnetic gap by sputtering (see, for example, U.S. Patent 3605258) but conventional cathodic sputtering techniques do not provide the magnetic gap with sufficient accuracy.

The reasons for this are that (i) the materials from which magnetic head elements are made, such as Mn-Zn ferrite, are often damaged by the plasma radiation during the sputtering deposition, (ii) the thickness accuracy for depositing film obtained in a conventional sputtering apparatus is around 10 to 20% at a production scale, and higher accuracy is necessary for making magnetic gaps, and (iii) reliable techniques for directly monitoring the thickness of sputtered glass layer on the magnetic core materials are not well established, because the well-known quartz thickness monitor system is not suitable for monitoring the glass layer thickness during the sputtering deposition.

The present invention provides an improvement in the known method of forming a glass spacer comprising cathodic sputtering of one or more glass layers onto magnetic head elements; according to the invention, the sputtering is effected using a sputtering target in apparatus in which the magnetic head elements to be coated by sputtering are secured in a sample holder for rotation around the target with the surfaces of the head elements to be coated facing in a direction transverse of the target, a mask plate fixed with respect to the target being interposed between the latter and the magnetic head elements for preventing sputtering of excess material onto the latter elements, and the thickness of the glass layer being monitored during sputtering by detecting interference between light reflected from the surface of the glass layer and light reflected from the interface between the glass layer and the head element.

The method according to the invention enables the thickness of the magnetic gap to be accurately controlled; the resultant heads have excellent electro-magnetic conversion characteristics and are suitable for use in video tape recording apparatus.

Damage to the head element is minimised according to the invention by providing the head elements facing a direction transverse of the target during sputtering; in the prior disclosed methods (for example, the method disclosed in U.S. Patent 3605258), the head elements face the target during deposition, with consequent risk of damage.

The monitoring of the thickness of dielectric glass layers during deposition thereof, by detecting interference between light reflected from the surface of the glass layer and light reflected from the glass layer/substrate interface is known in principle: an example of a disclosure of such a method is in an article by V. N. Chernyaev and others in Instrumental and Experimental Techniques, Vol. 17, No. 6, November-December 1974, pages 1781 to 1782.

In order that the present invention may be more fully understood, preferred embodiments thereof will now be described, by way of example, with reference to the accompanying drawings, in which:

Figure 1 is a perspective view of a magnetic head having a magnetic gap produced according to the invention;

Figures 2A and 2B are perspective and elevational views illustrating (Figure 2A) uncoated magnetic head elements and (Figure 2B) glass-coated magnetic head elements for use in the method according to the invention;

Figures 3A and 3B are schematic cross-sectional and perspective views of cathodic sputtering apparatus for use in the method according to the invention;

Figure 4 is a graph showing a typical characteristics of thickness distribution of a sputtered glass layer produced in the method according to the invention;

Figures 5A and 5B are graphs showing typical characteristics of a thickness monitoring system used in the method according to the invention;

Figure 6 is a perspective view illustrating the configuration of a thickness monitoring system for use in the method according to the invention;

Figure 7 is a perspective view illustrating a preferred configuration of a multi-target sputtering apparatus for use in the method according to the invention; and

Figure 8 is a perspective view illustrating a preferred configuration of a single-target sputtering apparatus for use in the method according to the invention.

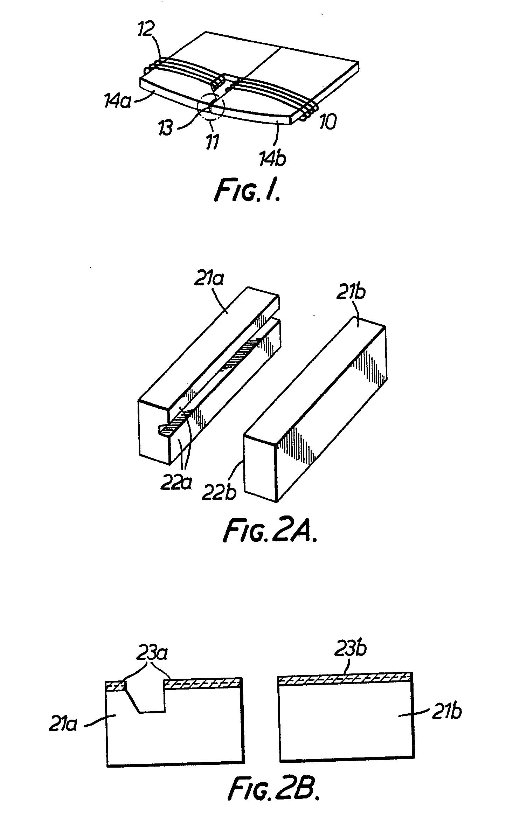

Referring to Figure 1, there is shown a magnetic head 10 having a thin magnetic gap 11 and a winding 12. The magnetic gap 11 is composed of a non-magnetic glass spacer element 13 which is sandwiched between a pair of magnetic head elements 14a and 14b.

Referring to Figure 2A, a magnetic core material such as Mn-Zn ferrite is first cut and machined to prepare a pair of unilateral head elements 21a and 21b having gap opposing faces 22a and 22b, then each gap opposing face is mirror finished. Referring to Figure 2B, each mirror finished gap opposing face is further subjected to cathodic sputtering to form thin non-magnetic glass layers 23a and 23b which are to serve as the magnetic gap. Finally, these unilateral head elements are butted against each other, with glass layers 23a and 23b sandwiched therebetween, and cemented together.

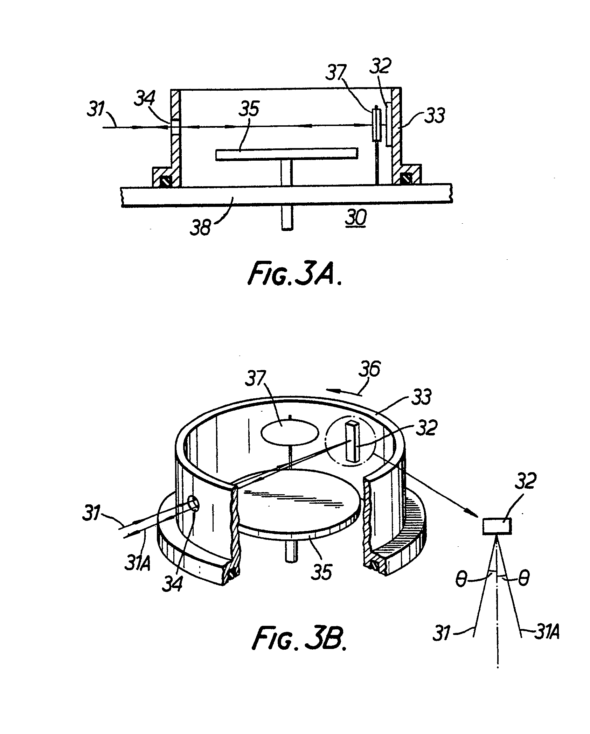

Referring to Figures 3A and 3B, there is shown sputtering apparatus 30 having a sample holder 33 to which the magnetic head elements 32 to be coated are attached, the sample holder 33 also serving as anode for the cathodic sputtering. The sample holder 33 has an opening 34 whereby a light beam 31 is guided onto the surface of the magnetic head elements 32. The sample holder 33 rotates around a cathode target 35 in the direction of the arrow 36. The sputtering apparatus has an elliptical mask plate 37 which prevents excess sputtered particles from the cathode target 35 from being deposited onto the magnetic head elements. The mask plate 37 is disposed between the target 35 and the magnetic head elements 32 and is secured to a base 38 of the cathodic sputtering apparatus 30. The cathode target 35, which may be composed of a glass such as borosilicate glass, is sputtered onto elements 32 by RF-sputtering.

Stainless steel or chromium metallized copper are preferably used for making the sample holder 33 since these materials can keep their surface clean during a long sputtering run. The magnetic head elements 32, which may be of Mn-Zn ferrite, for example, are preferably secured to the sample holder 33 by pressing by means of a flexible sheet-like spring so as to reduce surface damage which might arise from mechanical stress given by the sample holder 33, and also to ensure a reproducible reflected light signal. Such a sheet-like spring is preferably of stainless steel, chromium metallized spring steel or chromium metallized phosphor bronze. The metallization of such spring metals by chromium can reduce their surface contamination during sputtering deposition.

The sample holder 33 in the sputtering apparatus 30 preferably has a concave form in order to enhance light reflection during thickness monitoring. A cylindrical form is the most preferable structure for the sample holder.

The mask plate 37 is preferably in the form of a bent sheet, which ensures more uniform distribution of the sputtered glass layer during a long sputtering run. In a long sputtering run, the mask plate is often deformed by stress induced by the sputtered glass layer deposited on the mask plate. In order to minimise the deformation of the mask plate, the mask plate should be of a material such as stainless steel, silica glass or an alumina ceramic.

The arrangement of the cathodic sputtering apparatus 30 illustrated in Figure 3 enables the production of glass layers with high accuracy. In a conventional planar diode sputtering apparatus, a sample holder is disposed on an anode plate which faces a cathode target, whereas in the sputtering apparatus 30 shown in Figure 3, the sample holder 33 is disposed at the side of the cathode (this reduces radiation damage to the magnetic head elements). Again, in a conventional planar diode sputtering apparatus, large thickness distributions are observed whereas in the apparatus shown in Figure 3, the thickness distributions can be reduced by means of the mask plate 37.

Figure 4 shows the effect of the mask plate on the thickness distribution, the variation of the thickness distribution with the length of the magnetic head elements, without a mask plate being shown in curve 41, and the corresponding variation when using a mask plate being shown in curve 42. Without the mask plate, a large thickness distribution is observed and a maximum thickness is obtained at the centre of the magnetic head element, while with a mask plate and with rotation of the sample holder around the target, the thickness distribution was less than 2%. Various shapes of mask plate can be used, an ellipse-shaped plate being particularly suitable.

As mentioned above, in the method according to the present invention, the thickness of the sputtered glass layer is directly monitored during sputtering deposition. In the embodiment of Figures 3A and 3B, the monitoring is by detecting the intensity of the reflected light 31A (see Figure 3B).

The reflected light 31A comprises light reflected from the interface between the glass layer and the magnetic head element and also light reflected from the surface of the sputtered glass layer. Due to a small difference in the light path length 2d between these two reflected rays, there appears a phase difference $\Delta\phi \simeq 4\pi nd/\lambda$ between the two rays, where d and n denote the thickness and optical index of the sputtered glass layer, respectively, and $\lambda$, the wavelength of the light used. The resulting interference causes periodic variation in the light intensity with the thickness of the glass layer d, the period being given by $\lambda/2n$.

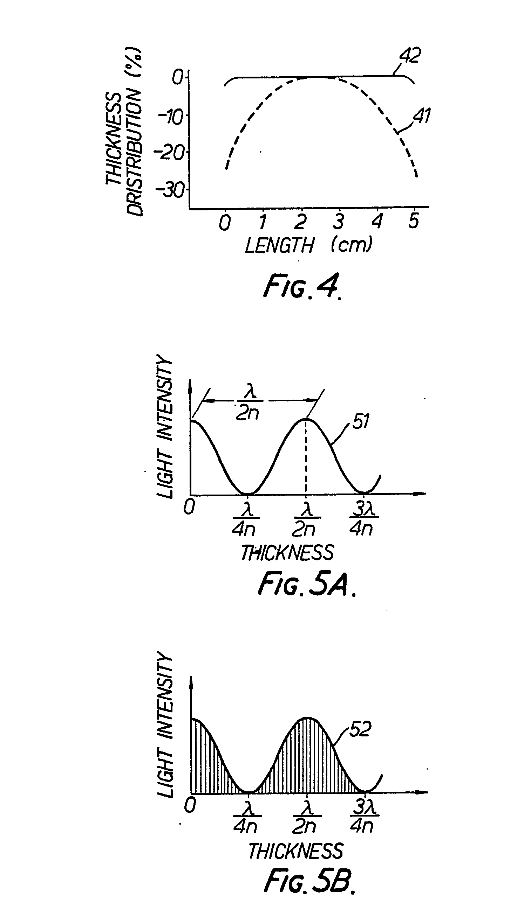

Figures 5A and 5B show the typical variation of the reflected light intensity with the thickness of sputtered glass layer d. Referring to Figure 5A, it will be understood that the thickness of the sputtered glass layer can be monitored during deposition by detecting the variation of the intensity of the reflected light, if the optical index n of the depositing glass layer and the wavelength $\lambda$ can be fixed.

The wavelength $\lambda$ can be easily fixed by using monochromatic light such as laser light. However, it is not well understood whether the value n can be fixed or not, because the chemical composition of the sputtered glass layer may not be fixed in a production scale. This may result in a variation of n in a production of the glass layer.

However, when the cathode target is made of borosilicate glass and the target is sputtered by RF-sputtering, the n of the sputtered glass layer is scarcely found to vary for a long sputtering run; this enables the glass layer to be produced with a highly accurate thickness and high reproducibility. The variation in the thickness of the glass layer is preferably not more than 1 to 2%. In order to ensure such accuracy, it is preferred that the half wavelength of the light beam should be shorter than the thickness of the glass layer, and preferably $\lambda < 8$ d/n.

When the sample holder rotates around the target the actual electrical signal obtained from the reflected light beam becomes pulsed signals 52, as shown in Figure 5B, and the accuracy of measuring the thickness of the glass layer is determined by the separation of these pulsed signals. The high rotating speeds improve the accuracy, and the rotating speed N (r.p.m.) of the sample holder should be $N > 50\ V_{dep}/n$, where $V_{dep}$ denotes the deposition speed of the glass layer per minute. For keeping these preferred conditions, when the magnetic gap thickness is greater than 0.25 micrometres, the He-Ne gas laser having $\lambda = 6328$ Å is preferably used. The $V_{dep}$ is typically 20 Å/min, whereby if $n \simeq 1.5$, then $N > 0.1$ the optimum value of N being from 0.3 to 1. Higher values of N are not generally usable in a vacuum system.

We have found that, according to the present invention, in a large production scale a glass layer of thickness variation less than 2% can be obtained under the optimum monitoring conditions described hereinbefore and this enables to make magnetic heads with high reproducibility. Referring again to Figure 3B, for an incident angle $\theta$, of the light beam onto the surface of the magnetic head elements 32, it has been found that the angle for monitoring the thickness of the glass layer is 0.3 to 10°, more preferably 0.5 to 5°. At an angle of less than 0.3°, the reflected light beam 31A and the incident light beam 31 tend to overlap, which causes the difficulty in measuring the reflected light intensity with high accuracy, while at an angle greater than 10°, the dimensions of the opening 34 must be increased; this results in a decrease in the amount of magnetic elements which can be processed in one sputtering run. For a sputtering system with a cylindrical sample holder having a diameter of 10 to 30 cm, the angle is preferably 0.5 to 5°. The beam width of the light beam is preferably less than 1 mm.

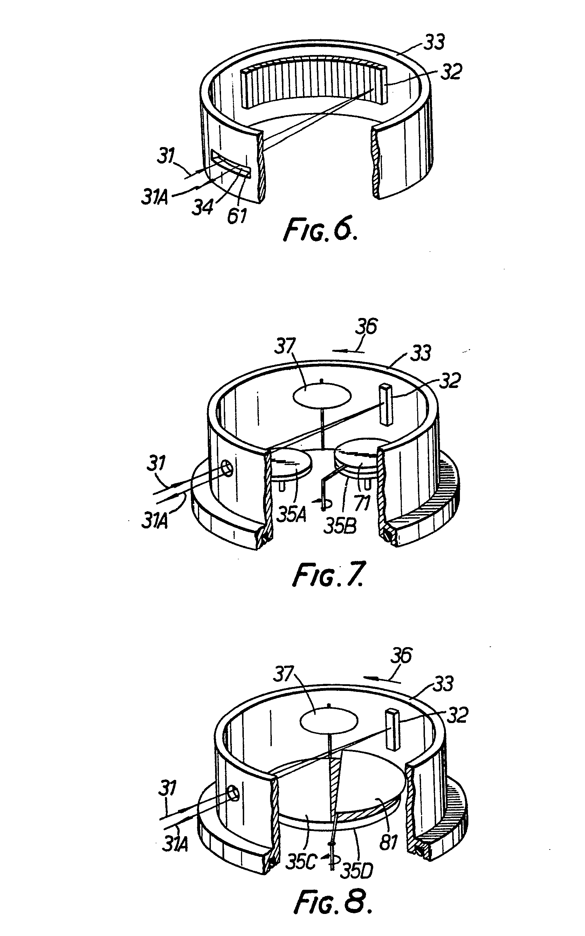

It has been found that the opening 34 disturbs the uniformity of the sputtered glass layer near the opening, sometimes causing thickness variation near the opening of several percents. In order to minimise such variation in thickness, the opening 34 preferably has a narrow rectangular form 61 (see Figure 6). The long rectangular opening which extends around the circumference of the cylindrical sample holder 33 ensures a high degree of reflection of light. If the opening is too wide, this disturbs the uniform discharge for the sputtering and causes non-uniform deposition of the glass layer on the magnetic head elements 32. The length and the width of the opening 34 are typically around 20 mm and 3 mm, respectively.

In order to minimise the disturbance of said opening to sputtering discharge more effectively, the opening 34 is preferably covered with electrically conductive, optically transparent glass, such as NESA glass. When such a covering is employed, little variation in the thickness of the sputtered glass layer is observed.

In the sputtering apparatus 30, the diameter for the target 35 is typically 20 to 30 cm, and the distance between the target edge and the magnetic head elements 32 is typically 2 to 7 cm. The target may be of a borosilicate glass, such as Pyrex glass (Corning Co. products), and sputtering is typically carried out in a mixed gas of argon and oxygen at $5 \times 10^{-2}$ Torr, at a target power density of 0.5 to 2 watt/cm². The temperature of the magnetic head elements during sputtering may be from ambient temperature to 300°C and the rate of deposition of the glass layer is typically 0.05 to 0.15 micrometres per hour. These sputtering configurations and operating conditions are found to produce glass layers on magnetic head elements with high accuracy in a large production scale.

In a magnetic head, the magnetic gap thickness is usually 0.3 to 1 micrometre for video signals, while for an audio head the gap thickness is somewhat greater. A high deposition speed is desired for the latter type of head but, in general, the glass layer peels from the magnetic head elements when the deposition speed becomes higher than about 0.15 microns per hour because of the stress included in the glass layer.

In order to increase the deposition speed of the glass layer, it has been found that it is advantageous if the glass spacer element is comprised of a first layer and second layer; the first layer being deposited by RF-sputtering of a silica glass target or Vicor glass target (Corning Co. products) in argon gas, and the second layer being deposited by RF-sputtering of borosilicate glass target such as Pyrex glass target in a mixture of argon and oxygen. Since the above-mentioned first layer comprises high amounts of silicon oxides, it increases the adhesive force between the glass layer and the magnetic head elements, while the second layer acts as a gap spacer. In such a multilayered structure, a high deposition speed of the glass layer can be achieved; typically the deposition speed is 0.3 to 0.6 micrometres per hour.

In sputtering of the first layer, a mixture of argon and oxygen can be used instead of argon, but pure argon is preferred for a high deposition speed. In sputtering of the second layer, a mixture of argon and oxygen is used, but the oxygen partial pressure in a sputtering gas can reduce a target composition change in a long sputtering run. The preferred amount of oxygen in the mixture is 1 to 50% (more preferably 5 to 20%) since if less than 1% is used, the target composition changes in a long sputtering run, while if greater than 50%, the deposition speed tends to decrease.

It has also been found that a multilayered glass spacer element can be produced with high reproducibility by RF-cathodic sputtering of a separate-target system. Referring to Figure 7, a suitable separate-target system comprises a silica glass target 35A and a borosilicate glass target 35B, and a shutter plate 71 which is positioned above the target. The sputtering deposition is carried out as follows: firstly the silica glass target is sputtered alone by covering borosilicate glass target 35B with the shutter plate 71 and then the borosilicate glass target 35B is sputtered alone by covering the silica glass target 35A with shutter plate 71.

In the separate-target system, the multi-layered spacer element can be deposited continuously without breaking vacuum in the sputtering apparatus. This enables the reflected light beam to be detected with higher accuracy, resulting in easy production of the magnetic head gap with high reproducibility.

Alternatively, an unitary-target system can be used, for example, as shown in Figure 8, in which a part 35C of a unitary-target is composed of silica glass and the rest 35D is composed of borosilicate glass. A shield plate 81 is positioned above the target, the spacing between the shield plate and the target surface being kept to be less than the cathode dark space in the sputtering discharge. The sputtering deposition is carried out as follows: firstly the silica glass part 35C of the target is sputtered alone by shielding the borosilicate glass part 35D of the target with the shield plate 81, and secondly the borosilicate glass part 35D is sputtered alone by shielding the silica glass part 35C of the target with the shield plate 81.

The above-mentioned unitary-target system provides simple operation of sputtering deposition since the RF-power for sputtering can be supplied to both glass target portions without using any electrical switching circuit. The shield plate located in the cathode dark space as described hereinbefore in place of electrical switching.

When a multi-layered spacer element is formed, the thickness of the first layer and second layer is typically 0.1 to 1 micrometre. The magnetic gap thus obtained has a thickness of, for instance, $0.3\pm0.01$ $\mu$m.

The examples described hereinbefore show the utility of RF-sputtering without any additional magnetic field. However, any other RF-sputtering system with additional magnetic field, including a sputtering system in which a magnetic field is parallel to the electrical field, or the magnetron sputtering system in which a magnetic field is transverse to the electrical field can also be used in the method of the invention. A planar magnetron target can also be used as the target 35 in the method according to the present invention.

The method according to the present invention is also applicable for making glass spacers in magnetic heads for computer systems. Magnetic metal heads, such as Sendust and Permalloy heads, can also be provided with glass spacers made by the method according to the present invention. In the exemplary process of making glass spacers in magnetic heads described hereinbefore, a pair of glass-coated magnetic head elements are cemented to each other. However, the glass spacers can also be produced according to the invention by cementing a glass-coated magnetic head element to a magnetic head element without any glass coating. Multi-layer including triple or four-fold structures can also be produced by the method according to the present invention, if desired. These multi-layered structures are usable for obtaining magnetic heads having wide magnetic gaps with excellent electromagnetic conversion characteristics.

**Claims**

1. A method of forming a glass spacer (13) within the magnetic gap (11) of a magnetic head, said glass spacer (13) being sandwiched between magnetic head elements (14a, 14b, Fig. 1), the spacer (13) being produced by cathodic sputtering of at least one glass layer (23a, 23b, Fig. 2B) onto one or both head elements (21a, 21b Fig. 2B) and cementing the head elements together with the glass layer or layers therebetween, characterised in that the sputtering is effected (Fig. 3A) using a sputtering target (35) in apparatus in which the magnetic head elements (32) to be coated by sputtering are secured in a sample holder (33) for rotation around the target (35) with the surfaces of the head elements (32) to be coated facing a direction transverse of the target (35), a mask plate (37) fixed with respect to the target (35) being interposed between the latter (35) and the magnetic head elements (32) for preventing sputtering of excess material onto the latter elements (32), and the thickness of the glass layer being monitored during sputtering by detecting interference between light reflected from the surface of the glass layer and light reflected from the interface between the glass layer and the head element.

2. A method according to claim 1, characterised in that the sample holder (33) is formed of stainless steel or chromium-plated copper.

3. A method according to claim 1 or 2, characterised in that the sample holder (33) is cylindrical.

4. A method according to any of claims 1 to 3, characterised in that the magnetic head elements (32) are secured in the sample holder by means of a sheet-like spring.

5. A method according to claim 4, characterised in that the sheet-like spring is formed of stainless steel, chromium-plated spring steel or chromium-plated phosphor bronze.

6. A method according to any of claims 1 to 5, characterised in that the mask plate (37, Fig. 3B) is elliptical and is formed of stainless steel, silica glass or an alumina ceramic.

7. A method according to any of claims 1 to 6, characterised in that the incident light (31, Fig. 6) used for monitoring the thickness of the glass layer enters the sample holder (33) through a narrow rectangular window (61).

8. A method according to any of claims 1 to 7, characterised in that the incident light used for monitoring the thickness of the glass layer enters the sample holder through a window of electrically conductive, optically transparent glass.

9. A method according to any of claims 1 to 8, characterised in that the or each head element (32, Fig. 7, 8) is coated by cathodic sputtering of at least two glass layers thereon, the first layer being applied by RF-sputtering of a silica glass target (35A, 35C) in argon gas and the second layer being applied by RF-sputtering of a borosilicate glass target (35B, 35D) in a mixture of argon and oxygen.

10. A method according to claim 9, characterised in that the silica glass target and the borosilicate glass target are both present in the apparatus during sputtering of the first and second layers either as separate targets (35A, 35B) or as a unitary target (35C, 35D), the borosilicate target (35B, 35D) being screened (71, 81) during sputtering of the first layer and the silica target (35A, 35C) being screened (71, 81) during sputtering of the second layer.

**Patentansprüche**

1. Verfahren zur Ausbildung eines Glas-Abstandsstückes (13) im Magnetspalt (11) eines Magnetkopfes, bei dem das Glas-Abstandsstück (13) sandwichartig zwischen Elementen (14a, 14b, Fig. 1) des Magnetkopfes angeordnet und das Abstandsstück (13) durch Katodenzerstäubung wenigstens einer Glasschicht (23a, 23b, Fig. 2B) auf ein oder beide Kopfelemente (21a, 21b, Fig. 2B) hergestellt und die Kopfelemente zusammen mit der Glasschicht oder Zwischenschichten verklebt werden, dadurch gekennzeichnet, daß die Zerstäubung unter Verwendung eines Zerstäubungs-Targets (35) in einer Vorrichtung erfolgt, in der die Magnetkopf-Elemente (32), die durch Zerstäubung beschichtet werden sollen, in einem Probenhalter (33) zur Drehung um das Target (35) angebracht sind, wobei die zu beschichtenden Oberflächen der Kopfelemente (32) einer Richtung zugewandt sind, die quer zu dem Target (35) verläuft, daß eine Maskenplatte (37), die in Bezug auf das Target (35) fixiert ist, zwischen letzterem (35) und den Magnetkopf-Elementen (32) angeordnet wird, um die Zerstäubung von überschüssigem Material auf die zuletzt erwähnten Elemente (32) zu verhindern, und daß die Dicke der Glasschicht während des Zerstäubens durch Feststellung von Interferenzen zwischen dem an der Oberfläche der Glasschicht reflektierten Licht und dem an der Zwischenfläche zwischen der Glasschicht und dem Kopfelement reflektierten Licht überwacht wird.

2. Verfahren nach Anspruch 1, dadurch gekennzeichnet, daß der Probenhalter (33) aus rostfreiem Stahl oder mit Chrom plattiertem Kupfer hergestellt wird.

3. Verfahren nach einem der Ansprüche 1 oder 2, dadurch gekennzeichnet, daß der Probenhalter (33) zylindrisch ist.

4. Verfahren nach einem der Ansprüche 1 bis 3, dadurch gekennzeichnet, daß die Magnetkopf-Elemente (32) in dem Probenhalter mittels einer blattförmigen Feder befestigt werden.

5. Verfahren nach Anspruch 4, dadurch gekennzeichnet, daß die blattförmige Feder aus rostfreiem Stahl, mit Chrom plattiertem Federstahl oder einer mit Chrom plattierten Phosphorbronze hergestellt wird.

6. Verfahren nach einem der Ansprüche 1 bis 5, dadurch gekennzeichnet, daß die Maskenplatte (37, Fig. 3B) elliptisch und aus rostfreiem Stahl, Quarz oder einem keramischen Aluminium-Oxid-Werkstoff hergestellt ist.

7. Verfahren nach einem der Ansprüche 1 bis 6, dadurch gekennzeichnet, daß das einfallende, für die Überwachung der Dicke der Glasschicht verwendete Licht (31, Fig. 6) durch ein schmales, rechteckiges Fenster (67) in den Probenhalter (33) eintritt.

8. Verfahren nach einem der Ansprüche 1 bis 7, dadurch gekennzeichnet, daß das einfallende, für die Überwachung der Dicke der Glasschicht dienende Licht in den Probenhalter durch ein Fenster aus einem elektrisch leitenden, optisch transparenten Glas eintritt.

9. Verfahren nach einem der Ansprüche 1 bis 8, dadurch gekennzeichnet, daß das oder jedes Kopfelement (32, Fig. 7B) durch Katodenzerstäubung mit wenigstens zwei Glasschichten beschichtet wird, wobei die erste Schicht durch Hochfrequenz-Zerstäubung eines Quarzglas-Targets (35A, 35C) in Argon-Glas und die zweite Schicht durch Hochfrequenz-Zerstäubung eines Borsilikat-Glas-Targets (35B, 35D) in einem Gemisch aus Argon und Sauerstoff aufgebracht wird.

10. Verfahren nach Anspruch 9, dadurch gekennzeichnet, daß sowohl das Quarzglas-Target als auch das Borsilikat-Glas-Target in der Vorrichtung während der Zerstäubung der ersten und zweiten Schicht entweder als getrennte Targets (35A, 35B) oder als einstückiges Target (35C, 35D) vorhanden sind, wobei das Borsilikat-Glas-Target (35B, 35D) während der Zerstäubung der ersten Schicht und das Quarglas-Target (35A, 35C) während der Zerstäubung der zweiten Schicht abgeschirmt (71, 81) werden.

## Revendications

1. Un procédé de formation d'une entretoise en verre (13) dans l'entrefer magnétique (11) d'une tête magnétique, cette entretoise en verre (13) étant intercalée entre des éléments de tête magnétique (14a, 14b, Figure 1), l'entretoise (13) étant produite par pulvérisation cathodique d'au moins une couche de verre (23a, 23b, Figure 2B) sur l'un des éléments de tête (21a, 21b, Figure 2B) ou sur les deux, et par collage des éléments de tête ensemble avec la ou les couches de verre entre eux, caractérisé en ce qu'on effectue la pulvérisation cathodique (Figure 3A) en utilisant une cible de pulvérisation cathodique (35) dans l'appareil dans lequel les éléments de tête magnétique (32) à revêtir par pulvérisation cathodique sont fixés dans un porte-échantillon (33) de façon à tourner autour de la cible (35), avec les surfaces des éléments de tête (32) à revêtir faisant face à une direction transversale par rapport à la cible (35), une plaque de masque (37), fixe par rapport à la cible (35) est intercalée entre cette dernière (35) et les éléments de tête magnétique (32) pour empêcher la pulvérisation cathodique d'un excès de matière sur les éléments de tête (32), et l'épaisseur de la couche de verre est contrôlée pendant la pulvérisation cathodique par la détection d'interférences entre la lumière réfléchie par la surface de la conche de verre et la lumière réfléchie par la frontière entre la couche de verre et l'élément de tête.

2. Un procédé selon la revendication 1, caractérisé en ce que le porte-échantillon (33) consiste en acier inoxydable ou en cuivre chromé.

3. Un procédé selon la revendication 1 ou 2, caractérisé en ce que le porte-échantillon (33) est cylindrique.

4. Un procédé selon l'une quelconque des revendications 1 à 3, caractérisé en ce que les éléments de tête magnétique (32) sont fixés dans le porte-échantillon au moyen d'un ressort à lame.

5. Un procédé selon la revendication 4, caractérisé en ce que le ressort à lame est en acier inoxydable, en acier à ressort chromé ou en bronze phosphoreux chromé.

6. Un procédé selon l'une quelconque des revendications 1 à 5, caractérisé en ce que la plaque de masque (37, Figure 3B) est elliptique et est en acier inoxydable, en verre de silice ou en céramique à base d'alumine.

7. Un procédé selon l'une quelconque des revendications 1 à 6, caractérisé en ce que la lumière incidente (31, Figure 6) qu'on utilise pour contrôler l'épaisseur de la couche de verre entre dans le porte-échantillon (33) en traversant une fenêtre rectangulaire étroite (61).

8. Un procédé selon l'une quelconque des revendications 1 à 7, caractérisé en ce que la lumière incidente qu'on utilise pour contrôler l'épaisseur de la couche de verre entre dans le porte-échantillon en traversant une fenêtre en verre optiquement transparent et conducteur de l'électricité.

9. Un procédé selon l'une quelconque des revendications 1 à 8, caractérisé en ce que l'élément de tête ou chaque élément de tête (32, Figures 7, 8) est revêtu par pulvérisation cathodique d'au moins deux couches de verre, la première couche étant appliquée par pulvérisation cathodique radiofréquence d'une cible en verre de silice (35A, 35C) dans un gaz consistant en argon, et la seconde couche étant appliquée par pulvérisation cathodique radiofréquence d'une cible en verre au borosilicate (35B, 35D) dans un mélange d'argon et d'oxygène.

10. Un procédé selon la revendication 9, caractérisé en ce que la cible en verre de silice et la cible en verre au borosilicate sont toutes deux présentes dans l'appareil pendant la pulvérisation cathodique de la première couche et de la seconde couche, soit sous la forme de cibles séparées (35A, 35B), soit sous la forme d'une cible unitaire (35C, 35D), et la cible en borosilicate (35B, 35D) est masquée (71, 81) pendant la pulvérisation cathodique de la première couche, tandis que la cible en silice (35A, 35C) est masquée (71, 81) pendant la pulvérisation cathodique de la seconde couche.

FIG. 1.

FIG. 2A.

FIG. 2B.

**Fig. 3A.**

**Fig. 3B.**

FIG. 4.

FIG. 5A.

FIG. 5B.

FIG.6.

FIG.7.

FIG.8.

4